(19) Europäisches Patentamt / European Patent Office / Office européen des brevets

(11) **EP 3 186 887 B1**

(12) **EUROPÄISCHE PATENTSCHRIFT**

(45) Veröffentlichungstag und Bekanntmachung des Hinweises auf die Patenterteilung:
**16.01.2019 Patentblatt 2019/03**

(21) Anmeldenummer: **15750749.2**

(22) Anmeldetag: **17.08.2015**

(51) Int Cl.:
**H03H 9/02** (2006.01)  **H03H 9/205** (2006.01)
**H03H 9/58** (2006.01)  **H03H 9/60** (2006.01)
**H03H 9/05** (2006.01)  **H03H 9/70** (2006.01)

(86) Internationale Anmeldenummer:
**PCT/EP2015/068845**

(87) Internationale Veröffentlichungsnummer:
**WO 2016/030222 (03.03.2016 Gazette 2016/09)**

(54) **FILTERCHIP UND VERFAHREN ZUR HERSTELLUNG EINES FILTERCHIPS**

FILTER CHIP AND METHOD OF MANUFACTURING A FILTER CHIP

FILTRE SUR PUCE ET PROCÉDÉ DE FABRICATION D'UN FILTRE SUR PUCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.08.2014 DE 102014112372**

(43) Veröffentlichungstag der Anmeldung:
**05.07.2017 Patentblatt 2017/27**

(73) Patentinhaber: **SnapTrack, Inc.**
**San Diego, CA 92121 (US)**

(72) Erfinder:
• **JAEGER, Philipp Michael**
**212121 Wuxi, Jiangsu (TW)**
• **RUILE, Werner**
**80636 München (DE)**

(74) Vertreter: **Wegner, Hans**
**Bardehle Pagenberg Partnerschaft mbB**
**Patentanwälte, Rechtsanwälte**
**Prinzregentenplatz 7**
**81675 München (DE)**

(56) Entgegenhaltungen:
**EP-A1- 1 221 770**  **DE-B3-102012 111 889**
**US-A1- 2007 252 485**

• **JIA-HONG SUN ET AL: "A ZnO/silicon Lamb wave filter using phononic crystals", FREQUENCY CONTROL SYMPOSIUM (FCS), 2012 IEEE INTERNATIONAL, IEEE, 21. Mai 2012 (2012-05-21), Seiten 1-4, XP032205174, DOI: 10.1109/FCS.2012.6243611 ISBN: 978-1-4577-1821-2**

**Beschreibung**

Die vorliegende Erfindung betrifft einen Filterchip, der einen ersten, mit akustischen Volumenwellen arbeitenden Resonator und einen zweiten, mit akustischen Volumenwellen arbeitenden Resonator aufweist.

Für zahlreiche Anwendungen werden Filterschaltungen benötigt, die zwei Resonatoren mit einem voneinander unterschiedlichen Frequenzverhalten aufweisen. Dabei kann es sich beispielsweise um Resonatoren eines Duplexers oder um die Resonatoren einer Ladder-Type-Struktur handeln. Um einen Filterchip mit Resonatoren mit unterschiedlichem Frequenzverhalten zu realisieren, sind aufwändige Verfahren nötig. Beispielsweise könnte die Dicke zumindest einer der piezoelektrischen Schichten der beiden Resonatoren variiert werden, da über die Dicke einer piezoelektrischen Schicht die Resonanzfrequenz eines Volumenwellenresonators eingestellt werden kann. Es könnte auch eine Trimmschicht auf zumindest einem der Resonatoren aufgetragen werden. Diese Verfahren sind jedoch aufwändig und erfordern eine unterschiedliche Behandlung der beiden Resonatoren, die oftmals in getrennten Verfahrensschritten erfolgen muss.

Eine Aufgabe der vorliegenden Erfindung ist es daher, einen verbesserten Filterchip, der beispielsweise ein einfacheres Herstellungsverfahren ermöglicht, und ein entsprechendes Herstellungsverfahren anzugeben.

Das Dokument" A ZnO/silicon Lamb wave filter using photonic crystals"; Jia-Hong at al.; 2012"; Jia-Hong al.; 2012 bezieht sich auf ein ZnO / Silizium-Lamb-Wellenfilter unter Verwendung von photonischen Kristallen. Insbesondere wird ein schmales Bandpassfilter bestehend aus zwei Lamb-Wellen-Resonatoren mit einem photonischen Kristallgitter vorgestellt, bei dem die Resonatoren durch Einführen von zwei Liniendefekten in eine Silizium-basierte photonische Kristallplatte hergestellt werden. Das Dokument EP 1221770 A1 betrifft ein Verfahren zum Herstellen einer Vielzahl von BAW-Resonatoren auf einem einzelnen Substrat und dem entsprechenden Produkt, wobei die BAW-Resonatoren im Wesentlichen unterschiedliche Resonanzfrequenzen aufweisen. Das Verfahren umfasst die Schritte: Bereitstellen eines Substrats mit einer oberen Oberfläche; Abscheiden einer Isolationsstruktur auf der oberen Oberfläche des Substrats; Abscheiden einer ersten metallischen Schicht auf der Isolationsstruktur, wobei die erste metallische Schicht als eine untere Elektrode dient; und Abscheiden einer Schicht von piezoelektrischem Material auf der unteren Elektrode, um Dicken entsprechend jeder der unterschiedlichen Resonanzfrequenzen zu haben, wobei jede der unterschiedlichen Dicken an einem Ort angeordnet ist, an dem ein Resonator mit einer Resonanzfrequenz entsprechend der Dicke angeordnet werden soll.

Das Dokument US 2007/252485 A1 betrifft einen piezoelektrischen Dünnschichtresonator, der einen piezoelektrischen Film aufweist, der über einen Raum auf einem Substrat gebildet ist und an mindestens einem Ort auf dem Substrat getragen wird, eine obere Elektrode, die eine Vielzahl von Elektrodenschichten und einen Verbindungsteil, der die Elektrodenschichten miteinander verbindet, wobei jede der Elektrodenschichten auf dem piezoelektrischen Film mit der gleichen Breite und im gleichen Abstand wie die Breite angeordnet ist, eine untere Elektrode, die unter dem piezoelektrischen Film ausgebildet ist, eine erste ein Pad, das auf dem Substrat ausgebildet ist und elektrisch mit der oberen Elektrode verbunden ist, und ein zweites Pad, das auf dem Substrat ausgebildet ist und elektrisch mit der unteren Elektrode verbunden ist.

Das Dokument D4 bezieht sich auf einen elektroakustischen Wandler mit einer piezoelektrischen Schicht, die so aufgebaut ist, dass bei einem in räumlicher Richtung angelegten elektrischen Wechselfeld eine Schwingungsmode mit Schwingungen in drei Raumrichtungen angeregt wird.

Diese Aufgabe wird durch den Gegenstand des vorliegenden Anspruchs 1 gelöst. Ferner wird die Aufgabe durch das Verfahren gemäß dem zweiten unabhängigen Anspruch gelöst. Weitere Ausgestaltungen und vorteilhafte Ausführungsformen sind Gegenstand der weiteren Ansprüche.

**>>Die Erfindung ist definiert durch die unabhängigen Ansprüche<<**

Es wird ein Filterchip vorgeschlagen, der eine Verschaltung zumindest eines ersten und eines zweiten mit akustischen Volumenwellen arbeitenden Resonators aufweist, wobei der erste mit akustischen Volumenwellen arbeitende Resonator eine erste piezoelektrische Schicht aufweist, die derart strukturiert ist, dass der erste Resonator eine niedrigere Resonanzfrequenz aufweist als der zweite Resonator.

Der zweite mit akustischen Volumenwellen arbeitende Resonator weist ferner eine zweite piezoelektrische Schicht auf. Die zweite piezoelektrische Schicht kann unstrukturiert oder ebenfalls strukturiert sein.

Bei den mit akustischen Volumenwellen arbeitenden Resonatoren handelt es sich um sogenannte BAW-Resonatoren (BAW = Bulk Acoustic Wave Resonator). Bei einem BAW-Resonator wird ein elektrisches Signal mit Hilfe des piezoelektrischen Effekts in eine akustische Welle umgewandelt, die sich im Substrat (Bulk) ausbreitet. Jeder der beiden Resonatoren weist eine untere und eine obere Elektrode auf, wobei die jeweilige piezoelektrische Schicht zwischen der unteren und der oberen Elektrode angeordnet ist und wobei die untere Elektrode auf der Seite der jeweiligen piezoelektrischen Schicht angeordnet ist, die zu einem Chipsubstrat hinweist, und die obere Elektrode auf der gegenüberliegenden Seite der piezoelektrischen Schicht angeordnet ist. Zwischen der unteren und der oberen Elektrode kann nunmehr jeweils eine Wechselspannung angelegt werden, wodurch in der jeweiligen piezoelektrischen Schicht eine akustische Welle angeregt werden kann, wenn die Frequenz der Wechselspannung im Bereich der Eigenresonanz der jeweiligen piezoelektrischen Schicht liegt.

Bei dem ersten und bei dem zweiten Resonator kann es sich um einen Film Bulk Acoustic Resonator (FBAR) oder um einen Solid Mounted Bulk Acoustic Resonator (SMR) handeln. Ein Film Bulk Acoustic Resonator ist freischwingend angeordnet, wobei sich unterhalb des Resonators eine Kavität befindet. Ein Solid Mounted Resonator ist auf einem akustischen Spiegel angeordnet.

Die erste und die zweite piezoelektrische Schicht können jeweils Aluminiumnitrid aufweisen oder aus Aluminiumnitrid bestehen. Auch andere piezoelektrische Materialien können für die piezoelektrischen Schichten verwendet werden.

Die erste piezoelektrische Schicht ist wie in Anspruch 1 angegeben strukturiert. Auch die zweite piezoelektrische Schicht kann eventuell strukturiert werden. Dieses ermöglicht es, die jeweilige Resonanzfrequenz des ersten und des zweiten Resonators gezielt einzustellen. Als Strukturieren wird hier das gezielte Entfernen eines Teils der jeweiligen piezoelektrischen Schicht bezeichnet. Vor dem Strukturieren kann die jeweilige piezoelektrische Schicht aus unstrukturierten Block bestehen, der keine Öffnungen oder Hohlräume aufweist. Bei dem Strukturieren wird nunmehr Material aus diesem Block entfernt, beispielsweise indem Gruben durch den Block gebildet werden, wobei das piezoelektrische Material in den Gruben entfernt wird. Insbesondere können der erste und eventuell auch der zweite Resonator derart strukturiert sein, dass sie eine voneinander unterschiedliche Resonanzfrequenz aufweisen. Dieses wird durch ein Strukturieren der ersten und eventuell auch der zweiten piezoelektrischen Schicht erreicht, so dass der Filterchip mit einem deutlich vereinfachten Herstellungsverfahren gefertigt werden kann. Insbesondere können die erste und die zweite piezoelektrische Schicht in einem gemeinsamen Verfahrensschritt zunächst unstrukturiert auf dem Chip aufgebracht werden. Anschließend kann die erste piezoelektrische Schicht fotolithografisch strukturiert werden, sodass die Resonanzfrequenz des ersten Resonators stärker reduziert wird. Gegebenenfalls kann auch die zweite piezoelektrische Schicht in dem gleichen Verfahrensschritt fotolithographisch strukturiert werden, wobei die erste piezoelektrische Schicht stärker strukturiert wird als die zweite piezoelektrische Schicht, sodass die Resonanzfrequenz des ersten Resonators stärker reduziert wird. Aufwändige Verfahrensschritte wie etwa das Aufbringen einer Trimmschicht oder das Ändern der Dicke einer der piezoelektrischen Schicht können dementsprechend entfallen.

Das Strukturieren der ersten und eventuell auch der zweiten piezoelektrischen Schicht bietet ferner den Vorteil, dass es einfach zu realisieren ist und mit einer hohen Genauigkeit durchgeführt werden kann. Insbesondere lässt sich eine Resonanzfrequenz mittels Strukturieren der piezoelektrischen Schicht genauer einstellen als mittels Variation der Schichtdicke.

Die erste und eventuell auch die zweite piezoelektrische Schicht können derart strukturiert sein, dass bei dem Strukturieren zwischen 5 % und 90 % des Materials der jeweiligen piezoelektrischen Schicht entfernt wird, wobei mehr Material aus der ersten piezoelektrischen Schicht entfernt wird als auf der zweiten piezoelektrischen Schicht. Eine Strukturierung der jeweiligen piezoelektrischen Schicht führt neben dem Vorteil der gezielten Einstellung der Resonanzfrequenz auch dazu, dass der Kopplungsfaktor des jeweiligen Resonators erhöht wird. Ein hoher Kopplungsfaktor ermöglicht es, eine große Bandbreite des Filters zu realisieren.

Der erste mit akustischen Volumenwellen arbeitende Resonator kann eine Hauptmode in Dickenrichtung aufweisen, und wobei der zweite mit akustischen Volumenwellen arbeitende Resonator kann ebenfalls eine Hauptmode in Dickenrichtung aufweisen. Als Dickenrichtung kann dabei die Richtung von einer oberen Elektrode, die auf einer Seite einer piezoelektrischen Schicht angeordnet ist, zu einer unteren Elektrode, die auf der gegenüberliegenden Seite der piezoelektrischen Schicht angeordnet ist, bezeichnet.

Die erste piezoelektrische Schicht ist mit Gruben strukturiert die durch die erste piezoelektrische Schicht hindurchlaufen. Alternativ oder ergänzend kann die zweite piezoelektrische Schicht mit Gruben strukturiert sein, die durch die zweite piezoelektrische Schicht hindurchlaufen. Als Grube wird hierbei eine Ausnehmung bezeichnet, die sich durch die jeweilige piezoelektrische Schicht hindurch erstreckt. Die Grube kann sich ferner auch durch die jeweilige obere Elektrode und eventuell auch durch die jeweilige untere Elektrode hindurch erstrecken.

Die Gruben lassen sich in einem fotolithographischen Verfahren einfach fertigen. Durch die Wahl des Durchmessers der Gruben und/oder durch die Wahl der Anzahl der Gruben kann der gewünschte Grad der Strukturierung der jeweiligen piezoelektrischen Schicht gezielt eingestellt werden. Je stärker die piezoelektrische Schicht strukturiert ist, desto stärker wird die Resonanzfrequenz abgesenkt.

Die Gruben können dabei eine beliebige Form haben. Sie können beispielsweise zylinderförmig oder quaderförmig sein. Es sind jedoch auch andersartig geformte Gruben denkbar.

Bei dem fotolithographischen Verfahren kann zunächst eine Lackschicht auf dem ersten und dem zweiten Resonator aufgebracht werden. Dann kann die Lackschicht mit Hilfe einer Maske teilweise belichtet werden und anschließend entwickelt werden. Nunmehr kann ein Ätzprozess durchgeführt werden, beispielsweise ein Trockenätzen, ein Plasmaätzen, Ion-Milling, ein Reactive Ion Ätzen oder ein nasschemisches Ätzen. Dabei kann die gewünschte Strukturierung erreicht werden. Die Strukturierung kann ein Muster in der xy-Ebene erzeugt werden, das wegen seiner Ausbildung in der xy-Ebene auch als laterale Strukturierung bezeichnet wird. Das Ätzen kann dafür sorgen, dass dieses Muster in Form von Gruben in vertikaler Richtung durch den jeweiligen Resonator hindurch verläuft.

In einer alternativen Ausführungsform laufen die Gruben nicht komplett durch die erste oder gegebenenfalls die zweite piezoelektrische Schicht hindurch, sondern verengen sich zunehmend, so dass sie Öffnungen in der jeweiligen piezoelektrischen Schicht ausbilden, die diese jedoch nicht komplett durchdringen.

In einigen Ausführungsformen kann zunächst in einem fotolithographischen Verfahren eine harte Maske erzeugt werden, die dann für das Ätzen benutzt werden kann. Dieses mehrschrittige Vorgehen kann insbesondere bei aggressiven Ätzvorgängen vorteilhaft sein.

Die Gruben sind vorzugsweise ungefüllt. Alternativ können die Gruben mit einer Füllschicht gefüllt sein, wobei die Füllschicht beispielsweise ein anormales thermomechanisches Verhalten aufweisen kann. Dementsprechend könnte die Füllschicht das thermomechanische Verhalten der jeweiligen piezoelektrischen Schicht kompensieren. Die Innenseiten der Gruben können in einer alternativen Ausgestaltung mit einer Mantelschicht bedeckt sein. Die Mantelschicht kann ein anormales thermomechanisches Verhalten aufweisen und/oder dazu dienen, die Gruben vor Umwelteinflüssen zu schützen.

Die erste und/oder die zweite piezoelektrische Schicht können derart strukturiert sein, dass sich die Gruben in einer vertikalen Richtung durch die erste und/oder die zweite piezoelektrische Schicht erstrecken. Die Richtung, die parallel zu den Flächennormalen der Elektroden ist, ist die vertikale Richtung. Die laterale Richtung kann ferner definiert sein als Richtung, die senkrecht zu den Flächennormalen der Elektroden ist.

Die erste und die zweite piezoelektrische Schicht können die gleiche Dicke aufweisen. Da durch die unterschiedliche Strukturierung der ersten und der zweiten piezoelektrischen Schicht die Resonanzfrequenzen des ersten und des zweiten Resonators unterschiedlich eingestellt werden können, ist es nicht erforderlich die Dicken der beiden Schichten voneinander abweichend auszugestalten. Vielmehr können die erste und die zweite piezoelektrische Schicht in einem gemeinsamen Verfahrensschritt mit gleicher Dicke hergestellt werden und ihre Dicke muss anschließend nicht mehr verändert werden. Die erste und die zweite piezoelektrische Schicht können sich jedoch auch in ihren Dicken unterscheiden. Für bestimmte Anwendungen kann es vorteilhaft sein, wenn die erste und die zweite piezoelektrische Schicht eine voneinander unterschiedliche Dicke aufweisen, um die beiden Resonanzfrequenzen noch stärker voneinander abzugrenzen.

Ferner können der erste und/oder der zweite Resonator eine Trimmschicht aufweisen. Wie oben beschrieben, ist grundsätzlich das Aufbringen einer Trimmschicht zur Realisierung unterschiedlicher Resonanzfrequenzen nicht mehr erforderlich, da die erste und die zweite piezoelektrische Schicht unterschiedlich zueinander strukturiert sind. Dennoch kann es für bestimmte Anwendungen vorteilhaft sein, zusätzlich eine Trimmschicht vorzusehen, um die beiden Resonanzfrequenzen noch stärker voneinander abzugrenzen. Das Aufbringen einer zusätzlichen Trimmschicht auf zumindest einen der beiden Resonatoren erhöht somit die Designflexibilität.

Als Trimmschicht wird hier eine Schicht bezeichnet, die von der piezoelektrischen Schicht verschieden ist. Die Trimmschicht kann es ermöglichen, durch die Wahl ihrer Dicke die Resonanzfrequenz des Resonators einzustellen. Die Trimmschicht befindet sich meist oberhalb der piezoelektrischen Schicht. Die Trimmschicht kann unmittelbar auf der oberen Elektrode des jeweiligen Resonators aufgebracht sein. Bei der Trimmschicht kann es sich um eine $SiO_2$-Schicht handeln. Durch das Aufbringen bzw. durch die Wahl der Dicke der Trimmschicht kann die Resonanzfrequenz des jeweiligen Resonators eingestellt werden. Auch die obere Elektrode selbst oder Teile der Elektrode können als Trimmschicht wirken.

Die erste piezoelektrische Schicht und/oder die zweite piezoelektrische Schicht können auf einem akustischen Spiegel angeordnet sein. Dabei kann insbesondere die untere Elektrode des jeweiligen Resonators zwischen der piezoelektrischen Schicht und dem akustischen Spiegel ausgebildet sein. Der akustische Spiegel sorgt dafür, dass akustische Volumenwellen, die in den Spiegel eindringen, reflektiert werden und zurück in den Resonator gestrahlt werden, sodass Verluste minimiert werden können. Es kann sich dementsprechend bei dem Resonator um einen sogenannten Solid Mounted Resonator handeln.

Ferner können der erste Resonator und/oder der zweite Resonator freischwingend angeordnet sein. Dabei kann unterhalb der unteren Elektrode des jeweiligen Resonators ein Hohlraum angeordnet sein. Es handelt sich dementsprechend um einen Film Bulk Acoustic Resonator oder einen Thin Film Bulk Acoustic Resonator.

Die erste piezoelektrische Schicht und/oder die zweite piezoelektrische Schicht können als eine Phononic Bandgap Struktur ausgebildet sein. In einer Phononic Bandgap Struktur breiten sich in zwei oder drei Raumrichtungen in einem Stoppbandfrequenzbereich keine akustischen Laufwellen aus. Dadurch können Verluste durch Abstrahlung in lateraler Richtung minimiert werden.

Der erste und der zweite Resonator können in einer Ladder-Type-Struktur, die einen Serienresonator und einen Parallelresonator aufweist, miteinander verschaltet sein, wobei der erste Resonator den Serienresonator oder den Parallelresonator ausbildet und wobei der zweite Resonator den jeweils anderen ausgewählt aus Serienresonator oder Parallelresonator ausbildet. Dabei sind der erste und der zweite Resonator im Falle eines Bandpassfilters vorzugsweise derart strukturiert, dass die Durchlassfrequenz des Serienresonators mit der Sperrfrequenz des Parallelresonators annähernd übereinstimmt.

Eine Ladder-Type-Filterstruktur kann einen Signalpfad mit einem Signalpfadeingang und einem Signalpfadausgang aufweisen. Ein Serienresonator ist seriell in dem Signalpfad verschaltet. Ein Parallelresonator ist derart verschaltet, dass eine Elektrode des Parallelresonators mit dem Signalpfad verschaltet ist und die andere Elektrode des Parallelresonators über ein Reaktanzelement mit Masse verbunden ist.

Filterschaltungen mit Ladder-Type-Strukturen können aus mehreren seriell verschalteten Grundgliedern aufgebaut sein, wobei ein Grundglied im Wesentlichen aus einem Serienresonator und einem Parallelresonator besteht. Die charakteristische Durchlassfrequenz des Serienresonators stimmt dabei ungefähr mit der Sperrfrequenz des Parallelresonators überein. Damit bildet ein solches Grundglied für sich ein Bandpassfilter. Die rechte Flanke der Dämpfungscharakteristik des Passbands wird maßgeblich von der konkreten Ausgestaltung des Serienresonators bestimmt, während die linke Flanke maßgeblich von der Ausgestaltung des Parallelresonators bestimmt wird. Der Filterchip kann ein solches Grundglied sein.

Insbesondere können der erste und der zweite Resonator jeweils ein FBAR-Resonator sein. Alternativ können sie SMR-Resonatoren sein.

Der Filterchip kann auch mehr als zwei Resonatoren aufweisen. Insbesondere kann der Filterchip noch weitere Resonatoren aufweist, die sich in ihrer Resonanzfrequenz von dem ersten und dem zweiten Resonator unterscheiden.

Beispielsweise kann der Filterchip als Duplexer ausgeführt sein, wobei mindestens ein erster und mindestens ein zweiter Resonator zu einem Sendefilter miteinander verschaltet sind, wobei der Filterchip ferner mindestens einen dritten Resonator und mindestens einen vierten Resonator aufweist, die miteinander zu einem Empfangsfilter verschaltet sind, wobei der erste Resonator, der zweite Resonator, der dritte Resonator und der vierte Resonator jeweils eine voneinander unterschiedliche Resonanzfrequenz aufweisen

Dabei kann der Filterchip beispielsweise einen ersten bis einen vierten Resonator mit einer ersten bis vierten piezoelektrischen Schicht aufweisen. Dabei können beispielsweise der erste Resonator und der zweite Resonator den Sendefilter bilden und der dritte Resonator und der vierte Resonator den Empfangsfilter bilden. Dementsprechend kann jeder der vier Resonatoren derart ausgestaltet sein, dass er eine Resonanzfrequenz aufweist, die von den Resonanzfrequenzen der jeweils anderen drei Resonatoren abweicht. Beispielsweise kann der erste Resonator am stärksten strukturiert sein, so dass er die niedrigste Resonanzfrequenz aufweist. Ferner kann der zweite Resonator weniger stark strukturiert sein als der erste Resonator, so dass er die zweitniedrigste Resonanzfrequenz aufweist. Ferner kann der dritte Resonator weniger stark strukturiert sein als der zweite Resonator, so dass er die drittniedrigste Resonanzfrequenz aufweist. Ferner kann der vierte Resonator weniger stark strukturiert sein als der dritte Resonator, so dass er die höchste Resonanzfrequenz aufweist. Es ist auch möglich, dass der vierte Resonator unstrukturiert ist. Ferner können die Resonanzfrequenzen der vier Resonatoren zusätzlich über die jeweilige Dicke und/oder das Aufbringen einer Trimmschicht beeinflusst werden.

Die hier für einen Filterchip mit zwei Resonatoren beschriebenen Merkmale können auch für einen Filterchip mit mehr als zwei Resonatoren realisiert sein.

Weitere Beispiele für akustische Bauelemente, die durch den Filterchip realisiert sein könnten sind ein L-Glied, ein Notch-Filter, Brückenschaltungen, ein T-Glied, ein P-Glied, ein Diplexer, ein Triplexer oder ein Quadruplexer.

Gemäß einem weiteren Aspekt wird ein Verfahren zur Herstellung eines Filterchips vorgeschlagen. Das Verfahren weist die Schritte des Anspruchs 14 oder des Anspruchs 15 auf.

Insbesondere können die erste und die zweite piezoelektrische Schicht zunächst in einem gemeinsamen Verfahrensschritt unstrukturiert auf dem Chipsubstrat aufgebracht werden. Anschließend können die erste und eventuell auch die zweite piezoelektrische Schicht in einem gemeinsamen Verfahrensschritt fotolithografisch strukturiert werden. Dabei kann eine Maske verwendet werden, die zu einer stärkeren Strukturierung der ersten fotopiezoelektrischen Schicht führt, sodass die Resonanzfrequenz des ersten Resonators stärker reduziert wird.

Insbesondere kann bei dem Verfahren der oben beschriebene Filterchip gefertigt werden. Dementsprechend kann jedes strukturelle oder funktionelle Merkmal, das im Zusammenhang mit dem Filterchip offenbart wurde, auch für das Verfahren zutreffen.

Das Verfahren zur Herstellung des Filterchips kann somit ferner den folgenden Schritte aufweist: fotolithographisches Strukturieren der zweiten piezoelektrischen Schicht. Dabei kann die zweite piezoelektrische Schicht in einem geringeren Maße strukturiert werden als die erste piezoelektrische Schicht, so dass der erste Resonator eine geringere Resonanzfrequenz als der erste Resonator aufweist. Das Strukturieren der ersten und der zweiten piezoelektrischen Schichten kann in einem gemeinsamen Verfahrensschritt vorgenommen werden.

Die erste und die zweite piezoelektrische Schicht können zunächst in einem gemeinsamen Verfahrensschritt unstrukturiert auf dem Chipsubstrat aufgebracht werden.

Im Folgenden wird die Erfindung anhand von Figuren näher erläutert.

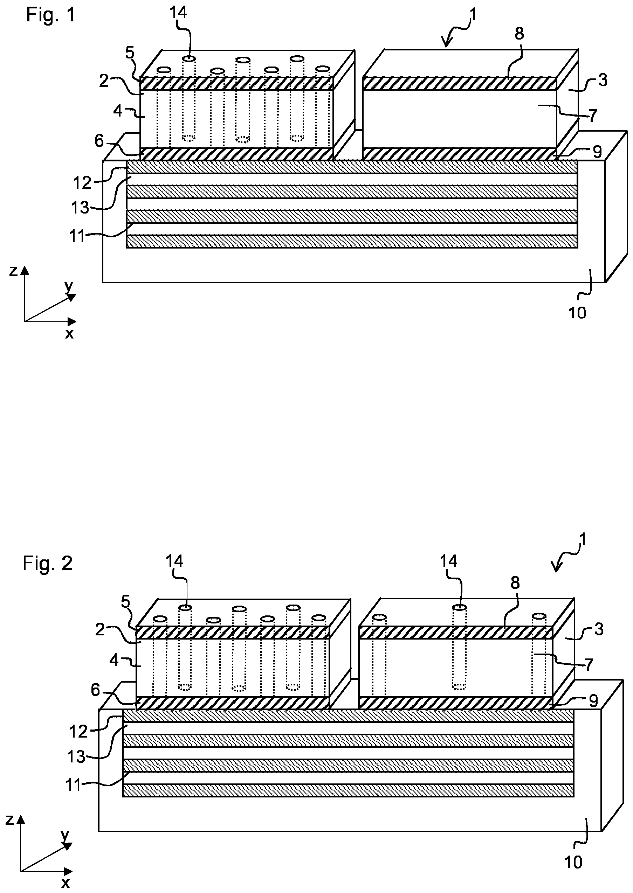

Figur 1                                zeigt einen Querschnitt durch einen Filterchip eines BAW-Resonators des Typs SMR.

| Figur 2 | zeigt einen weiteren Querschnitt durch einen Filterchip eines BAW-Resonators des Typs SMR. |
|---|---|
| Figur 3 | zeigt ein Diagramm, bei dem die Amplitude der Admittanz für verschiedene Resonatoren in logarithmischem Maßstab aufgetragen ist. |
| Figur 4 | zeigt ein erstes Ausführungsbeispiel einer strukturierten piezoelektrischen Schicht in einer Draufsicht auf die xy-Ebene. |
| Figuren 5a bis 5f, 6, 7a, 7b, 8 und 9 | zeigen weitere Ausführungsbeispiele von strukturierten piezoelektrischen Schichten, jeweils in einer Draufsicht auf die xy-Ebene. |

Figur 1 zeigt einen Filterchip 1. Der Filterchip 1 weist einen ersten, mit akustischen Volumenwellen arbeitenden Resonator 2 und einen zweiten, mit akustischen Volumenwellen arbeitenden Resonator 3 auf.

Der erste, mit akustischen Volumenwellen arbeitende Resonator 2 weist eine erste piezoelektrische Schicht 4 auf, die zwischen einer oberen Elektrode 5 und einer unteren Elektrode 6 angeordnet ist. Ferner weist auch der zweite, mit akustischen Volumenwellen arbeitende Resonator 3 eine zweite piezoelektrische Schicht 7 auf, die zwischen einer oberen Elektrode 8 und einer unteren Elektrode 9 angeordnet ist. Die unteren Elektroden 6, 9 sind jeweils auf der zu einem Chipsubstrat 10 hinweisenden Seite der jeweiligen piezoelektrischen Schicht 4, 7 angeordnet. Die oberen Elektroden 5, 8 sind jeweils auf der von dem Chipsubstrat 10 wegweisenden Seite der jeweiligen piezoelektrischen Schicht 4, 7 angeordnet.

Der erste und der zweite Resonator 2, 3 weisen eine identische Dicke auf. Insbesondere ist die erste piezoelektrische Schicht 4 genauso dick wie die zweite piezoelektrische Schicht 7. Die erste und die zweite piezoelektrische Schicht 4, 7 können jeweils Aluminiumnitrid aufweisen oder aus Aluminiumnitrid bestehen.

Der erste und der zweite Resonator 2, 3 sind auf einem gemeinsamen Chipsubstrat 10 angeordnet. Das Chipsubstrat weist Silizium auf. Unterhalb der beiden Resonatoren 2, 3 ist ein akustischer Spiegel 11 ausgebildet. Der akustische Spiegel 11 weist abwechselnd angeordnete erste Schichten 12 und zweite Schichten 13 auf, wobei die zweiten Schichten 13 sich in ihrer akustischen Impedanz von den ersten Schichten 12 unterscheiden. Der akustische Spiegel 11 besteht beispielsweise aus abwechselnd angeordneten Schichten aus $SiO_2$ und Wolfram.

Die erste piezoelektrische Schicht 4 ist strukturiert. Die piezoelektrischen Schichten 4 wurden in einem fotolithografischen Verfahren strukturiert. Die Strukturierung weist Gruben 14 auf, die durch die piezoelektrische Schichten 4 hindurch verlaufen. Die Gruben 14 erstrecken sich dabei in der vertikalen Richtung.

In Figur 1 bezeichnet die z-Richtung die Richtung, die durch die Flächennormale der Elektroden 5, 6, 8, 9 bestimmt ist. Diese wird als vertikale Richtung bezeichnet. Die Gruben 14 erstrecken sich in z-Richtung. Die y-Richtung ist senkrecht zur vertikalen Richtung. Die x-Richtung ist senkrecht zur y-Richtung und senkrecht zur z-Richtung. Sowohl die y-Richtung als auch die x-Richtung werden als laterale Richtung bezeichnet. Figur 1 zeigt den Filterchip 1 somit in einem Querschnitt durch die x-z-Ebene.

Die Strukturierung der piezoelektrischen Schicht 4 führt dazu, dass die Resonanzfrequenz des ersten Resonators 2 verschoben wird. Insbesondere wird die Resonanzfrequenz des ersten Resonators 2 umso mehr verringert, desto stärker die erste piezoelektrische Schicht 4 strukturiert ist. Eine stärke Strukturierung ist dabei gleichbedeutend damit, dass mehr Material der ersten piezoelektrischen Schicht 4 entfernt wurde. Durch die Strukturierung der ersten piezoelektrischen Schicht 4 des ersten Resonators 2 weist dieser eine niedrigere Resonanzfrequenz als der zweite Resonator 4 auf.

Figur 2 zeigt einen weiteren Filterchip 1, der sich von dem in Figur 1 gezeigten Filterchip 1 lediglich dahingehend unterscheidet, dass bei dem in Figur 2 gezeigten Filterchip 1 auch die zweite piezoelektrische Schicht 7 strukturiert ist. Die zweite piezoelektrische Schicht 7 wurde hier in einem fotolithographischen Verfahren strukturiert. Insbesondere wurden die erste und die zweite piezoelektrische Schicht in einem gemeinsamen Verfahrensschritt fotolithographisch strukturiert. Auch die zweite piezoelektrische Schicht 7 weist Gruben 14 auf, die sich in vertikaler Richtung durch die zweite piezoelektrische Schicht 7 hindurch erstrecken.

Die zweite piezoelektrische Schicht 7 ist weniger stark strukturiert als die erste piezoelektrische Schicht 4, d. h. bei der Strukturierung wurde aus der ersten piezoelektrischen Schicht 4 mehr Material entfernt als aus der zweiten piezoelektrischen Schicht 7. Aus diesem Grund weist der erste Resonator 2 eine niedrigere Resonanzfrequenz auf als der zweite Resonator 3.

Die Gruben 14 sind sowohl in dem in Figur 1 gezeigten Ausführungsbeispiel als auch in dem in Figur 2 gezeigten Ausführungsbeispiel ungefüllt. In alternativen Ausführungsbeispielen können sie vollständig mit einer Füllschicht gefüllt sein. Alternativ kann lediglich ihre Innenseite mit einer Mantelschicht bedeckt sein. Die Füllschicht und/oder die Mantelschicht können ein Material aufweisen, das ein anomales thermomechanisches Verhalten aufweist. Dieses Material kompensiert das normale thermomechanische Verhalten der jeweiligen piezoelektrischen Schicht 4, 7. Insbesondere kann sich das Material auf Grund des anormalen thermomechanischen Verhaltens bei Erwärmung versteifen.

Ferner können die Füllschicht und/oder die Mantelschicht die jeweilige piezoelektrische Schicht 4, 7 gegen Umwelteinflüsse schützen. Beispielsweise können die Füllschicht und/oder die Mantelschicht für eine Passivierung sorgen.

In einem ersten Ausführungsbeispiel können der erste Resonator 2 und der zweite Resonator 3 miteinander zu einem Ladder-Type Filter verschaltet sein, wobei einer der beiden Resonatoren 2, 3 einen Parallelresonator und der andere Resonator einen Serienresonator ausbildet.

Ferner können zwei solcher Filterchips 1 zu einem Duplexer verschaltet sein, wobei die jeweiligen Resonanzfrequenzen der Resonatoren durch eine entsprechende Strukturierung angepasst sind. Es ist auch möglich, vier Resonatoren auf einem einzigen Filterchip anzuordnen. Dabei können diese vier Resonatoren jeweils so strukturiert sein, dass sie voneinander abweichende Resonanzfrequenzen aufweisen. Beispielsweise können die vier Resonatoren zu zwei Ladder-Type Filtern verschaltet sein, die den Sendefilter und den Empfangsfilter eines Duplexers bilden.

In einem weiteren Ausführungsbeispiel können der erste und der zweite Resonator 2, 3 auf dem Filterchip 1 zu einer Notch-Struktur miteinander verschaltet sein, wobei einer der Resonatoren 2, 3 einen Parallelresonator und der jeweils andere Resonator einen Serienresonator ausbildet.

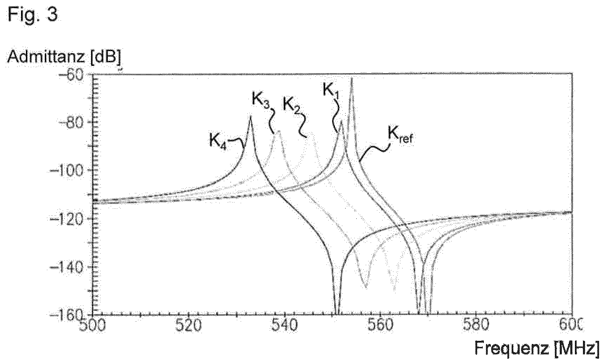

Figur 3 zeigt in einem Diagramm die Auswirkungen der Strukturierung auf das Frequenzverhalten eines Resonators 2. Auf der Abszissenachse ist dabei die Frequenz in MHz aufgetragen. Auf der Ordinatenachse ist die Amplitude der Admittanz in einem logarithmischen Maßstab aufgetragen.

Figur 3 zeigt zunächst eine Referenzkurve $K_{ref}$, die das Frequenzverhalten eines Resonators mit unstrukturierter piezoelektrischer Schicht zeigt. Ferner sind in Figur 2 die Kurven $K_1$, $K_2$, $K_3$ und $K_4$ aufgetragen, die jeweils das Frequenzverhalten eines Resonators mit strukturierter piezoelektrischer Schicht beschreiben, wobei die jeweilige piezoelektrische Schicht hier mit Löchern strukturiert ist und der Durchmesser der Löcher von Kurve $K_1$ zu Kurve $K_4$ jeweils zunimmt.

Es ist Figur 3 zu entnehmen, dass die Resonanzfrequenz und die Antiresonanzfrequenz der Resonatoren 2 durch ein Strukturieren der jeweiligen piezoelektrischen Schicht 4 nach unten verschoben werden. Dabei ist diese Verschiebung umso größer, je stärker die piezoelektrische Schicht 4 strukturiert ist, d. h. je mehr Material aus der piezoelektrischen Schicht 4 entfernt wurde.

Ferner zeigt Figur 3, dass der Polnullstellenabstand der Resonatoren 2 umso größer wird, je stärker die piezoelektrische Schicht 4 strukturiert ist. Der Polnullstellenabstand eines Resonators 2 ist definiert als Abstand von Resonanzfrequenz und Antiresonanzfrequenz.

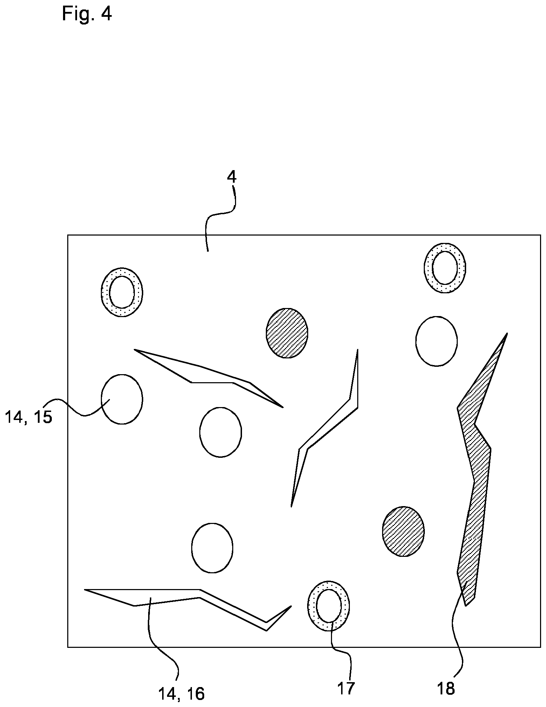

Figur 4 zeigt eine Draufsicht auf die x-y-Ebene auf eine piezoelektrische Schicht 4, bei der die Gruben zufällig angeordneten Löcher 15 und Schlitze 16 bilden. Die Löcher 15 und die Schlitze 16 erstrecken sich in vertikaler Richtung durch die piezoelektrische Schicht 4 hindurch. Es kann sich bei der piezoelektrischen Schicht um die erste piezoelektrische Schicht 4 handeln. Wie oben beschrieben, kann die zweite piezoelektrische Schicht 7 entweder unstrukturiert bleiben oder auf ähnliche Weise, aber in geringerem Maße, wie der erste piezoelektrische Schicht 4 strukturiert sein.

Einige Löcher 15 sind mit einer Mantelschicht 17 bedeckt, die ein anomales thermomechanisches Verhalten aufweist. Diese Mantelschicht 17 wirkt dem normalen thermomechanischen Verhalten der piezoelektrischen Schicht 4 entgegen. Hierdurch ist eine teilweise Kompensation, eine vollständige Kompensation oder eine Überkompensation möglich. Auch die Seitenwände der Schlitze 16 könnten mit der Mantelschicht 17 bedeckt werden.

Ferner sind einige der Löcher 15 und einige der Schlitze 16 mit einer Füllschicht 18 aus einem dielektrischen Material, das ein anormales thermomechanisches Verhalten aufweist, gefüllt. Es kann hierzu jedes Material, das ein anormales thermomechanisches Verhalten aufweist, verwendet werden. Ferner bleiben einige der Löcher 15 und Schlitze 16 frei von der Mantelschicht 17 und der Füllschicht 18.

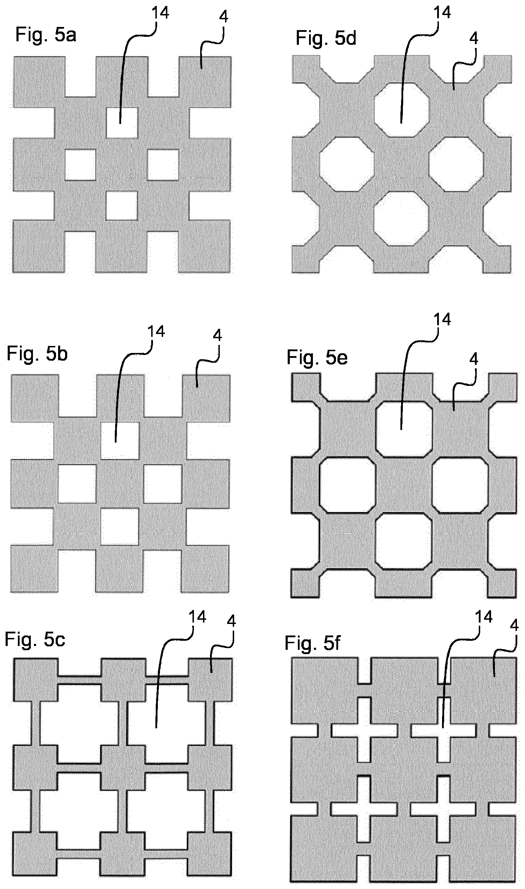

Die Figuren 5a bis 5f zeigen weitere Ausführungsbeispiele einer strukturierten piezoelektrischen Schicht 4. Die Figuren a bis f zeigen die piezoelektrische Schicht 4 dabei in einer Draufsicht auf die x-y-Ebene. Es kann sich auch hier, genauso wie bei den nachfolgenden Figuren, bei der piezoelektrischen Schicht um die erste oder die zweite piezoelektrische Schicht 4, 7 handeln.

Durch die gezeigten piezoelektrischen Schichten 4 erstrecken sich dabei in vertikaler Richtung Gruben 14. Durch diese Gruben 14 wird die jeweilige piezoelektrische Schicht 4 zu Blöcken strukturiert. Sind die Gruben 14 mit einem hinreichend kleinen Durchmesser ausgestaltet, so überlappen sich die Ecken der Blöcke, wie in Figur 5a und Figur 5b gezeigt. Wird der Durchmesser der Gruben 14 größer gewählt, so ist die piezoelektrische Schicht 4 zu Blöcken strukturiert, die durch Stege miteinander verbunden sind, wie in den Figuren 5c bis 5f gezeigt. Bei einigen Ausführungsbeispielen verbindet ein Steg je zwei Blöcke an ihren Ecken, wie in Figur 5d und Figur 5e gezeigt. In anderen Ausführungsbeispielen sind die Blöcke durch Stege an ihren Seitenflächen miteinander verbunden sind, wie in Figur 5c und Figur 5f gezeigt.

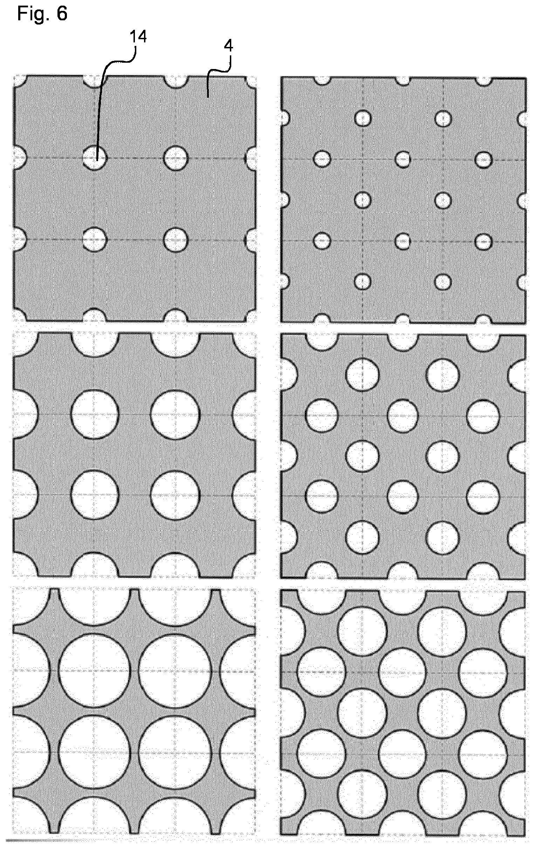

Figur 6 zeigt weitere Ausführungsbeispiele einer strukturierten piezoelektrischen Schicht 4, die auch hier in einer Draufsicht auf die x-y-Ebene dargestellt ist. Die in Figur 6 gezeigten piezoelektrischen Schichten 4 sind durch Gruben 14 mit einem kreisförmigen Durchschnitt strukturiert. In den verschiedenen Abbildungen der Figur 6 weisen die Gruben 14 unterschiedliche Durchmesser auf. Je größer der Durchmesser der Grube 14 ist, umso stärker wird die Resonanzfrequenz verringert und umso größer wird der Polnullstellenabstand des Resonators 2.

Die Durchmesser der Gruben 14 können beispielsweise zwischen 0,2 und 6 $\mu$m liegen.

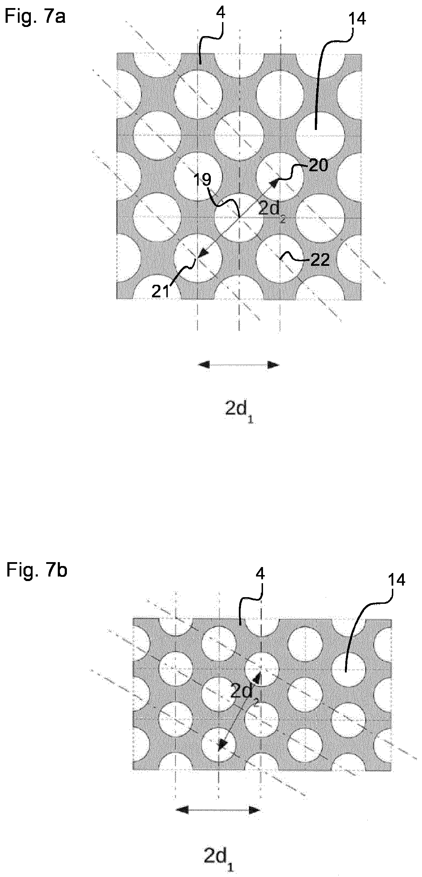

Figur 7a und Figur 7b zeigen zwei weitere Ausführungsbeispiele einer strukturierten piezoelektrischen Schicht 4. Die piezoelektrischen Schichten 4 sind in den Figuren 7a und 7b ebenfalls in einer Draufsicht auf die x-y-Ebene gezeigt. Die piezoelektrischen Schichten 4 sind jeweils durch Gruben 14 mit einem kreisförmigen Querschnitt strukturiert. Die piezoelektrischen Schichten 4 sind jeweils derart strukturiert, dass eine Phononic Bandgap Struktur ausgebildet wird. Die Phononic Bandgap Struktur sorgt insbesondere dafür, dass Abstrahlverluste in lateraler Richtung minimiert werden können.

In vertikaler Richtung (z-Richtung) sorgt bei SMR Resonatoren der akustische Spiegel und bei FBAR Resonatoren die freie Randbedingung für Reflexionen der akustischen Welle und sorgt so für eine Verlustminimierung. Ist ferner eine zweidimensionale Phononic Bandgap Struktur ausgebildet, so minimiert diese die Abstrahlverlust in lateraler Richtung.

Die Gruben 14 sind in Spalten und Zeilen angeordnet, wobei die Spalten in y-Richtung verlaufen. Die Gruben 14 zweier benachbarter Spalten sind dabei gegeneinander versetzt. Die Gruben sind derart periodisch zu Spalten angeordnet, dass die Anordnung der Gruben 14 zweier Spalten, zwischen denen genau eine weitere Spalte angeordnet ist, identisch ist.

Wie in Figur 7a gezeigt, wird mit $d_2$ der Abstand der Mittelpunkte 19, 20 von zwei Gruben 14 bezeichnet, wobei die erste Grube 14 in einer ersten Spalte angeordnet ist und die andere Grube 14 in der unmittelbar benachbarten Spalte angeordnet ist und am nächsten zu der ersten Grube 14 liegt. Ferner bezeichnet $2d_1$ den Abstand der Mittelpunkte 21, 22 von zwei Gruben 14, wobei die erste Grube 14 in einer ersten Spalte angeordnet ist und die andere Grube 14 in der nächstgelegenen Spalte mit identischer Grubenanordnung liegt und in dieser Spalte am nächsten zu der ersten Grube liegt. Eine Phononic Bandgap Struktur wird ausgebildet, wenn $d_1$ und $d_2$ folgende Bedingung erfüllen:

$$d_2/d_1 = \sqrt{2}$$

Eine Phononic Bandgap Struktur kann auch einfacher bzw. besser mittels anderer Konstruktionsvorschriften erlangt werden. Ein Beispiel dafür ist in der Figur 7b dargestellt. Dabei sind $2d_1$ und $2d_2$ wie in der Figur 7b gezeigt definiert. Eine Phononic Bandgap Struktur ergibt sich, wenn $d_1$ und $d_2$ folgende Bedingung erfüllen:

$$d_2/d_1 = 0,5 \times \sqrt{3}$$

In diesem Zusammenhang spricht man auch von einer hexagonalen Anordnung.

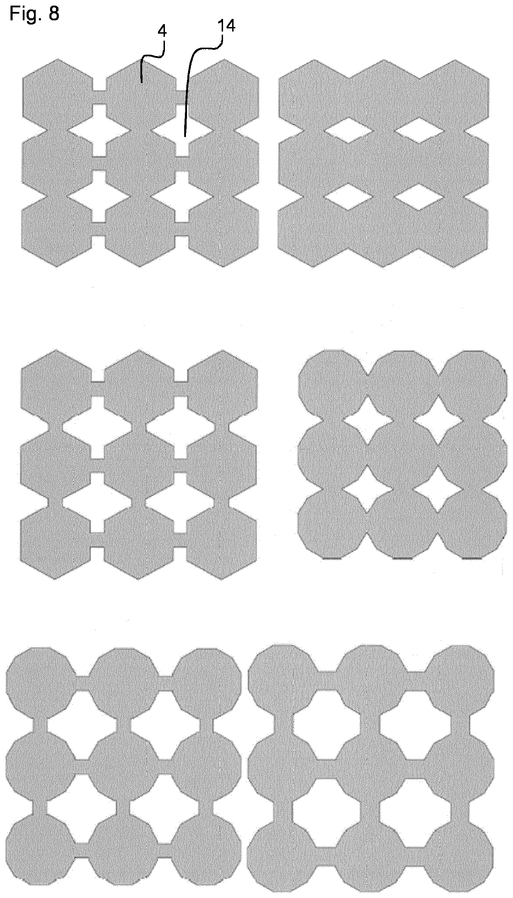

Figur 8 zeigt weitere Ausführungsbeispiele von strukturierten piezoelektrischen Schichten 4, wobei die piezoelektrischen Schichten 4 jeweils zu Blöcken mit hexagonalen oder dodekagonalen Grundflächen strukturiert sind. In einigen der gezeigten Ausführungsbeispiele gehen diese Blöcke ineinander über, in anderen Ausführungsbeispielen sind sie über Stege miteinander verbunden.

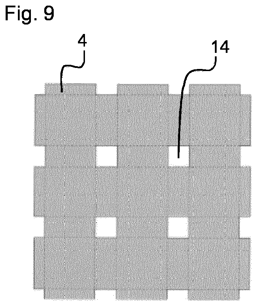

Figur 9 zeigt ein weiteres Ausführungsbeispiel einer strukturierten piezoelektrischen Schicht 4. Die piezoelektrische Schicht ist zu Blöcken mit einer quadratischen Grundfläche strukturiert. Die Seitenflächen der Blöcke sind über Stege miteinander verbunden, wobei die Stege eine Breite haben, die der Seitenlänge der Blöcke entspricht.

Bezugszeichenliste

| 1 | Filterchip |
|---|---|
| 2 | erster Resonator |
| 3 | zweiter Resonator |
| 4 | erste piezoelektrische Schicht |
| 5 | obere Elektrode |
| 6 | untere Elektrode |
| 7 | zweite piezoelektrische Schicht |
| 8 | obere Elektrode |
| 9 | untere Elektrode |
| 10 | Chipsubstrat |

11    akustischer Spiegel
12    erste Schicht des akustischen Spiegels
13    zweite Schicht des akustischen Spiegels
14    Grube
15    Loch
16    Schlitz
17    Mantelschicht
18    Füllschicht
19    Mittelpunkt
20    Mittelpunkt
21    Mittelpunkt
22    Mittelpunkt

**Patentansprüche**

**1.**   Filterchip (1),
aufweisend eine Verschaltung zumindest eines ersten und eines zweiten mit akustischen Volumenwellen arbeitenden Resonators (2, 3),
wobei der erste mit akustischen Volumenwellen arbeitende Resonator (2) eine erste piezoelektrische Schicht (4) aufweist, die mit Gruben (14), die durch die erste piezoelektrische Schicht (4) hindurch laufen, derart strukturiert ist, dass der erste Resonator (2) eine niedrigere Resonanzfrequenz aufweist als der zweite Resonator (3).

**2.**   Filterchip (1) gemäß Anspruch 1,
wobei der erste mit akustischen Volumenwellen arbeitende Resonator (2) eine Hauptmode in Dickenrichtung aufweist, und
wobei der zweite mit akustischen Volumenwellen arbeitende Resonator (3) eine Hauptmode in Dickenrichtung aufweist.

**3.**   Filterchip (1) gemäß einem der vorherigen Ansprüche,
wobei die zweite piezoelektrische Schicht (7) unstrukturiert oder strukturiert ist.

**4.**   Filterchip (1) gemäß einem der vorherigen Ansprüche,
wobei die erste und/oder die zweite piezoelektrische Schicht (4, 7) derart strukturiert sind, dass sich Gruben (14) in einer vertikalen Richtung durch die erste und/oder die zweite piezoelektrische Schicht (4, 7) erstrecken.

**5.**   Filterchip (1) gemäß einem der vorherigen Ansprüche,
wobei die erste piezoelektrische Schicht (4) und die zweite piezoelektrische Schicht (7) die gleiche Dicke aufweisen.

**6.**   Filterchip (1) gemäß einem der vorherigen Ansprüche,
wobei der erste und/oder der zweite Resonator (2, 3) eine Trimmschicht aufweist.

**7.**   Filterchip (1) gemäß einem der vorherigen Ansprüche,
wobei der erste Resonator (2) und/oder der zweite Resonator (3) auf einem akustischen Spiegel (11) angeordnet ist.

**8.**   Filterchip (1) gemäß einem der vorherigen Ansprüche,
wobei der erste Resonator (2) und/oder der zweite Resonator (3) freischwingend angeordnet ist.

**9.**   Filterchip (1) gemäß einem der vorherigen Ansprüche,
wobei die erste piezoelektrische Schicht (4) und/oder die zweite piezoelektrische Schicht (7) eine Phononic Bandgap Struktur ausbildet.

**10.**  Filterchip (1) gemäß einem der vorherigen Ansprüche,
wobei der erste und der zweite Resonator (2, 3) in einer Ladder-Type-Struktur, die mindestens einen Serienresonator und mindestens einen Parallelresonator aufweist, miteinander verschaltet sind,
wobei der erste Resonator (2) den Serienresonator oder den Parallelresonator ausbildet, und
wobei der zweite Resonator (3) den jeweils anderen ausgewählt aus Serienresonator oder Parallelresonator ausbildet.

**11.** Filterchip (1) gemäß einem der vorherigen Ansprüche, der noch weitere Resonatoren aufweist, die sich in ihrer Resonanzfrequenz von dem ersten und dem zweiten Resonator (2, 3) unterscheiden.

**12.** Filterchip (1) gemäß einem der vorherigen Ansprüche, der als Duplexer ausgeführt ist, wobei mindestens der erste und zweite Resonator (2, 3) zu einem Sendefilter miteinander verschaltet sind, wobei der Filterchip (1) ferner mindestens einen dritten Resonator und mindestens einen vierten Resonator aufweist, die miteinander zu einem Empfangsfilter verschaltet sind, wobei der erste Resonator (2), der zweite Resonator (3), der dritte Resonator und der vierte Resonator jeweils eine voneinander unterschiedliche Resonanzfrequenz aufweisen.

**13.** Filterchip (1) gemäß einem der vorherigen Ansprüche, wobei der erste und der zweite Resonator (2, 3) ein FBAR Resonator oder ein SMR Resonator sind.

**14.** Verfahren zur Herstellung eines Filterchips (1), das die folgenden Schritte aufweist:

- Fertigen eines ersten mit akustischen Volumenwellen arbeitenden Resonators (2) mit einer ersten piezoelektrischen Schicht (4) auf einem Chipsubstrat (10),
- Fertigen eines zweiten mit akustischen Volumenwellen arbeitenden Resonators (3) mit einer zweiten piezoelektrischen Schicht (7) auf dem Chipsubstrat (10), und
- fotolithographisches Strukturieren der ersten piezoelektrischen Schicht (4), so dass die erste piezoelektrische Schicht mit Gruben (14), die durch die erste piezoelektrische Schicht (4) hindurch laufen, derart strukturiert ist, dass der erste Resonator (2) eine niedrigere Resonanzfrequenz aufweist als der zweite Resonator.

**15.** Verfahren zur Herstellung eines Filterchips (1) gemäß Anspruch 14, das ferner den folgenden Schritt aufweist:

- fotolithographisches Strukturieren der zweiten piezoelektrischen Schicht (7).


**Claims**

**1.** Filter chip (1), comprising
an interconnection of at least a first and a second resonator (2, 3) operating with acoustic volume waves, wherein the first resonator (2) operating with acoustic volume waves comprising a first piezoelectric layer (4) structured with grooves (14) passing through the first piezoelectric layer (4) such that the first resonator (2) has a lower resonance frequency than the second resonator (3).

**2.** Filter chip (1) according to claim 1,
the first resonator (2) operating with acoustic volume waves having a main mode in the thickness direction, and the second resonator (3) operating with acoustic volume waves having a main mode in the thickness direction.

**3.** Filter chip (1) according to one of the previous claims,
wherein the second piezoelectric layer (7) is unstructured or structured.

**4.** Filter chip (1) according to one of the previous claims,
wherein the first and/or the second piezoelectric layer (4, 7) are structured such that grooves (14) extend in a vertical direction through the first and/or the second piezoelectric layer (4, 7).

**5.** Filter chip (1) according to one of the previous claims,
wherein the first piezoelectric layer (4) and the second piezoelectric layer (7) have the same thickness.

**6.** Filter chip (1) according to one of the previous claims,
wherein the first and/or the second resonator (2, 3) comprises a trimming layer.

**7.** Filter chip (1) according to one of the previous claims,
wherein the first resonator (2) and/or the second resonator (3) are arranged on an acoustic mirror (11).

**8.** Filter chip (1) according to one of the previous claims,
wherein the first resonator (2) and/or the second resonator (3) is arranged to oscillate freely.

**9.** Filter chip (1) according to one of the previous claims,
wherein the first piezoelectric layer (4) and/or the second piezoelectric layer (7) forms a phononic bandgap structure.

**10.** Filter chip (1) according to one of the previous claims,
wherein the first and second resonators (2, 3) are interconnected in a ladder-type structure comprising at least one series resonator and at least one parallel resonator, wherein the first resonator (2) forms the series resonator or the parallel resonator, and the second resonator (3) forms the respective other resonator selected from series resonator or parallel resonator.

**11.** Filter chip (1) according to one of the previous claims,
which has further resonators which differ in their resonance frequency from the first and the second resonator (2, 3).

**12.** Filter chip (1) according to one of the previous claims,
which is implemented as a duplexer,
wherein at least a first and at least a second of the first and second resonators (2, 3) are interconnected to form a transmission filter,
wherein the filter chip (1) further comprises at least one third resonator and at least one fourth resonator which are interconnected to form a reception filter,
wherein the first resonator (2), the second resonator (3), the third resonator and the fourth resonator each have a mutually different resonance frequency.

**13.** Filter chip (1) according to one of the previous claims,
wherein the first and second resonators (2, 3) are an FBAR resonator or an SMR resonator.

**14.** Method for fabricating a filter chip (1), which comprises the following steps:

- fabricating a first resonator (2) operating with acoustic volume waves having a first piezoelectric layer (4) on a chip substrate (10),
- fabricating a second resonator (3) operating with acoustic volume waves having a second piezoelectric layer (7) on the chip substrate (10), and
- photolithographically structuring the first piezoelectric layer (4) such that the first piezoelectric layer is structured with grooves (14) passing through the first piezoelectric layer (4) such that the first resonator (2) has a lower resonance frequency than the second resonator.

**15.** Method for fabricating a filter chip (1) according to claim 14, which further comprises the following step:

- photolithographic structuring of the second piezoelectric layer (7).

**Revendications**

**1.** Filtre sur puce (1),
présentant un câblage d'au moins un premier et un deuxième résonateur (2, 3) fonctionnant avec des ondes acoustiques, dans lequel le premier résonateur (2) fonctionnant avec des ondes acoustiques présente une première couche piézoélectrique (4), qui est structurée avec des fosses (14), qui traversent la première couche piézoélectrique (4), de telle sorte que le premier résonateur (2) présente une fréquence de résonance inférieure à celle du deuxième résonateur (3).

**2.** Filtre sur puce (1) selon la revendication 1,
dans lequel le premier résonateur (2) fonctionnant avec des ondes acoustiques présente un mode principal dans le sens de l'épaisseur, et
dans lequel le deuxième résonateur (3) fonctionnant avec des ondes acoustiques présente un mode principal dans le sens de l'épaisseur.

**3.** Filtre sur puce (1) selon l'une quelconque des revendications précédentes,

dans lequel la deuxième couche piézoélectrique (7) est non structurée ou structurée.

4. Filtre sur puce (1) selon l'une quelconque des revendications précédentes,
dans lequel la première et/ou la deuxième couche piézoélectrique (4, 7) sont structurées de telle sorte que des fosses (14) s'étendent dans une direction verticale à travers la première et/ou la deuxième couche piézoélectrique (4, 7).

5. Filtre sur puce (1) selon l'une quelconque des revendications précédentes,
dans lequel la première couche piézoélectrique (4) et la deuxième couche piézoélectrique (7) présentent la même épaisseur.

6. Filtre sur puce (1) selon l'une quelconque des revendications précédentes,
dans lequel le premier et/ou le deuxième résonateur (2, 3) présente une couche d'équilibrage.

7. Filtre sur puce (1) selon l'une quelconque des revendications précédentes,
dans lequel le premier résonateur (2) et/ou le deuxième résonateur (3) est agencé sur un miroir acoustique (11).

8. Filtre sur puce (1) selon l'une quelconque des revendications précédentes,
dans lequel le premier résonateur (2) et/ou le deuxième résonateur (3) est agencé à oscillation libre.

9. Filtre sur puce (1) selon l'une quelconque des revendications précédentes,
dans lequel la première couche piézoélectrique (4) et/ou la deuxième couche piézoélectrique (7) forme une structure de bande interdite phononique.

10. Filtre sur puce (1) selon l'une quelconque des revendications précédentes,
dans lequel le premier et le deuxième résonateur (2, 3) sont câblés l'un à l'autre dans une structure de type échelle, qui présente au moins un résonateur série et au moins un résonateur parallèle,
dans lequel le premier résonateur (2) forme le résonateur série ou le résonateur parallèle, et
dans lequel le deuxième résonateur (3) forme respectivement l'autre choisi parmi le résonateur série ou le résonateur parallèle.

11. Filtre sur puce (1) selon l'une quelconque des revendications précédentes,
qui présente encore d'autres résonateurs, qui se distinguent dans leur fréquence de résonnance du premier et du deuxième résonateur (2, 3).

12. Filtre sur puce (1) selon l'une quelconque des revendications précédentes,
qui est réalisé en tant que duplexeur,
dans lequel au moins le premier et deuxième résonateur (2, 3) sont câblés l'un à l'autre en un filtre d'émission,
dans lequel le filtre sur puce (1) présente en outre au moins un troisième résonateur et au moins un quatrième résonateur, qui sont câblés l'un à l'autre en un filtre de réception,
dans lequel le premier résonateur (2), le deuxième résonateur (3), le troisième résonateur et le quatrième résonateur présentent respectivement une fréquence de résonance différente l'une de l'autre.

13. Filtre sur puce (1) selon l'une quelconque des revendications précédentes,
dans lequel le premier et le deuxième résonateur (2, 3) sont un résonateur FBAR ou un résonateur SMR.

14. Procédé de fabrication d'un filtre sur puce (1),
qui présente les étapes suivantes :

   - fabrication d'un premier résonateur (2) fonctionnant avec des ondes acoustiques avec une première couche piézoélectrique (4) sur un substrat de puce (10),
   - fabrication d'un deuxième résonateur (3) fonctionnant avec des ondes acoustiques avec une deuxième couche piézoélectrique (7) sur le substrat de puce (10), et
   - structuration photolithographique de la première couche piézoélectrique (4), de sorte que la première couche piézoélectrique est structurée avec des fosses (14), qui traversent la première couche piézoélectrique (4), de telle sorte que le premier résonateur (2) présente une fréquence de résonance inférieure à celle du deuxième résonateur.

**15.** Procédé de fabrication d'un filtre sur puce (1) selon la revendication 14, qui présente en outre l'étape suivante :

- structuration photolithographique de la deuxième couche piézoélectrique (7).

Fig. 1

Fig. 2

Fig. 3

Fig. 4

Fig. 5a

14

4

Fig. 5d

14

4

Fig. 5b

14

4

Fig. 5e

14

4

Fig. 5c

14

4

Fig. 5f

14

4

Fig. 6

Fig. 7a

$2d_1$

Fig. 7b

$2d_1$

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1221770 A1

- US 2007252485 A1

**In der Beschreibung aufgeführte Nicht-Patentliteratur**

- **JIA-HONG.** *A ZnO/silicon Lamb wave filter using photonic crystals,* 2012